# EUROPEAN PATENT APPLICATION

(11) **EP 2 447 193 A1**
(43) Date of publication of application: **02.05.2012**
(21) Application number: 10791854.2
(22) Date of filing: 23.06.2010
(51) Int. Cl.: B65G 1/06, H01L 21/673

(54) **STORAGE CONTAINER**

(30) Priority: 26.06.2009 JP 2009152695
(71) Applicant: Muratec Automation Co., Ltd., Minami-ku, Kyoto 601-8326 (JP)
(72) Inventor: MURATA, Masanao, Ise-shi Mie 516-0005 (JP); YAMAJI, Takashi, Ise-shi Mie 516-0005 (JP)
(74) Representative: Beck, Alexander
(86) International application number: PCT/JP2010/004162
(87) International publication number: WO 2010/150531

(57) **Abstract**

A storage container (20) comprises a main body (20a) provided with an opening (H1); a port (P1) which is adjacent to the opening (H1) outside the main body (20a) and on which a FOUP (3) can be placed; a plurality of rack portions (21) arranged in one horizontal direction at each of a plurality of levels within the main body (20a) and configured such that articles moved by an internal movement apparatus (30) can be put in place; a movable rack portion (23) having a first buffer (B1) and a second buffer (B2) which are linked to each other; a shift mechanism (39) that can be shifted between a first position where the first buffer (B1) is adjacent to the opening (H1) and a second position where the second buffer (B2) is adjacent to the opening (H1); and a conveyor (41) capable of moving the FOUP (3), via the opening (H1), between the port (P1) and the first buffer (B1) or the second buffer (B2) positioned at a position adjacent to the opening (H1).

## Description

### TECHNICAL FIELD

The present invention relates to the technical field of storage containers, such as a stocker, with which article such as a FOUP (front opening unified pod), which contains various kinds of substrates for manufacturing semiconductor elements, for example, is loaded and unloaded to and from a transporting carriage.

### BACKGROUND ART

A FOUP capable of holding a plurality of semiconductor wafers with a diameter of 300 mm, for example, has been disclosed as a article that is suitable for this kind of storage container (see Patent Literature 1, for example). A FOUP such as this is primarily used to convey or temporarily store a plurality of semiconductor wafers between a plurality of processes, or within each process, along the path of a transporting carriage in a facility in which the storage container is installed.

### CITATION LIST

### PATENT LITERATURE

Patent Literature 1: Japanese Laid-Open Patent Application 2007-123673

### SUMMARY OF INVENTION

### TECHNICAL PROBLEM

As to the semiconductor wafers held in the FOUP disclosed in the above-mentioned Patent Literature 1, their diameter is specified at 300 mm. However, in recent years, an increase in diameter has been observed, and a diameter of 450 mm is now being promoted, for example. This has been accompanied by a tendency for FOUPs to become larger and heavier. In light of this trend, it is expected that FOUPs will not only become larger in their width and depth dimensions, but also in height.

When a article is transferred (specifically, loaded or unloaded) in this storage container, typically to or from a ceiling-mounted carriage that travels along a track installed on the ceiling, a transfer component (specifically, a loading/unloading port) on which the article is temporarily placed is installed such that it protrudes to the side from the storage container main body.

To deal with the above-mentioned increase in FOUP size, the inventors of the present invention have proposed a storage container comprising a transfer component installed below a ceiling-mounted carriage that stops at a specific loading/unloading position along the track, with this transfer component being installed at a distance less than the height of one article. More precisely, at least the upper part of the article is located inside the ceiling-mounted carriage in a state where the article has been completely transferred on the transfer component from the ceiling-mounted carriage, for example. After this, when the article is transferred into the storage container from the transfer component, it moves horizontally through the side face of the ceiling-mounted carriage. In other words, even though the article is larger in size, little if any lowering of the installation location is needed in the vertical direction for the transfer component. Accordingly, larger articles can be accommodated while maintaining the height (that is, the "safe height") of the transfer component, at which safety can be ensured above the head of workers and so forth around the storage container.

Meanwhile, while moving from the ceiling-mounted carriage to the transfer component, since at least the upper part of the article remains inside the ceiling-mounted carriage, as long as the article is transferred on the transfer component, the ceiling-mounted carriage is unable to travel, which may result in inefficient transportation of the article by the ceiling-mounted carriage. More specifically, when a plurality of articles are transferred (that is, loaded) continuously onto the transfer component from a plurality of ceiling-mounted carriages, the loading from the plurality of ceiling-mounted carriages will not be finished unless the articles are moved away from the transfer component, which poses a technical problem in that the ceiling-mounted carriages may become backed up along the track.

The present invention was conceived in light of the above problems, and it is an object thereof to provide a storage container with which a safe height of the placement component or the like can be maintained at the loading port, while continuous loading can be carried out efficiently.

### SOLUTION TO PROBLEM

A plurality of modes will be described as means for solving the above problem. These modes can be suitably combined as needed.
The storage container pertaining to one aspect of the present invention is a storage container with which an article is loaded to and from a transporting carriage that transports the article and travels along a track provided on a ceiling. This storage container comprises a housing, a loading port, an internal movement apparatus, fixed rack portions, a rack portion shift apparatus, and an in-out movement apparatus. The housing has a plurality of levels therein that are arranged in the vertical direction, and has at least one entrance provided to correspond to at least one of the plurality of levels. The loading port is adjacent to the entrance on the outside of the housing and allows the article to be placed. The internal movement apparatus moves the article in at least one horizontal direction within the housing and also in the vertical direction. The plurality of fixed rack portions are arranged in the at least one horizontal direction at each of the plurality of levels within the housing, and are configured such that the article moved by the internal movement apparatus can be placed onto the fixed rack portions. The movable rack portion has a first rack portion and a second rack portion which are linked to each other. The rack portion shift apparatus allows the movable rack portion to be shifted between a first position , where the first rack portion is adjacent to the entrance and a second position, where the second rack portion is adjacent to the entrance. The in-out movement apparatus moves the article, via the entrance, between the loading port and the first rack portion or the second rack portion positioned adjacent to the entrance.

For example, when article is moved by the in-out movement apparatus from the loading port to the first rack portion adjacent to the entrance, the rack portion shift apparatus then shifts the movable rack from the first position to the second position. As a result, the second rack portion, on which no article has been placed, is adjacent to the entrance rather than the first rack portion. After this, the internal movement apparatus moves the first article placed on the first rack portion to the fixed rack portion, either before or after the in-out movement apparatus moves the second article from the loading port to the second rack portion. The rack portion shift apparatus then shifts the movable rack portion from the second position to the first position. As a result, an empty first rack portion is adjacent to the entrance rather than the second rack portion. Thus, as soon as an article is placed on the rack portion adjacent to the entrance, the rack portion on which the article has been placed is retracted, and a rack portion on which no article has been placed is brought adjacent to the entrance in its place, where it awaits the next article loaded from the loading port. Consequently, the article is quickly moved from the loading port to the movable rack portion, and the article spends less time placed at the loading port, or in other words, the transporting carriage spends less time stopped at the loading position.

As discussed above, at least two rack portions (also known as storage container buffers) are provided that allow the temporary placement of article that has been moved from the loading port into the storage container, and the two rack portions are adjacent to each other at the entrance during the loading. Consequently, continuous loading from the loading port can be carried out efficiently regardless of the operating state of the internal movement apparatus.

The constitution may be such that the first rack portion and the second rack portion are linked and arranged in a first direction parallel to the direction in which the track extends near the entrance, and the rack portion shift apparatus moves the movable rack portion in the first direction.

With this mode, when the movable rack portion is shifted between the first position and the second position by the rack portion shift apparatus, there is movement equivalent to the width of one rack portion, for example, in a direction parallel to the direction in which the track extends. Consequently, the rack portion adjacent to the entrance can be changed extremely quickly.

The constitution may be such that there is further provided a controller, and when a plurality of articles are to be loaded into the storage container, the controller controls the in-out movement apparatus so that a first article placed onto the loading port from a first transporting carriage is moved from the loading port onto the first rack portion, then controls the rack portion shift apparatus so that the movable rack portion is shifted from the first position to the second position, and then controls the in-out movement apparatus so that a second article placed onto the loading port from a second transporting carriage is moved from the loading port onto the second rack portion.

With this mode, the in-out movement apparatus and the rack portion shift apparatus are controlled in an orderly fashion, and a first article and a second article can be loaded continuously and efficiently.

A storage container pertaining to another aspect of the present invention is a storage container with which an article is to be loaded from a transporting carriage that transports the article and travels along a track provided on a ceiling, in order to solve the above-mentioned problems. This storage container comprises a housing, a loading port, an internal movement apparatus, a plurality of rack portions, an in-out movement apparatus, and an inter-rack portion movement apparatus. The housing has a plurality of levels that are arranged in the vertical direction, and at least one entrance through which article can be introduced is provided to correspond to at least one of the plurality of levels. The loading port is adjacent to the entrance on the outside of the housing, and allows the article to be placed. The internal movement apparatus moves the article in at least one horizontal direction within the housing and can also move in the vertical direction. The plurality of rack portions are arranged in at least the one horizontal direction at each of the plurality of levels within the housing, and are configured such that the article moved by the internal movement apparatus can be placed onto the rack portions. The in-out movement apparatus moves the article, via the entrance, between the loading port and a first rack portion adjacent to the entrance, among the plurality of rack portions. The inter-rack portion movement apparatus moves the article between the first rack portion and a second rack portion that is adjacent to the first rack portion, among the plurality of rack portions.

With this storage container, a roller mechanism, an arm mechanism, or other such inter-rack portion movement apparatus are provided to afford continuous loading. For example, when the in-out movement apparatus moves a first article from the loading port to the first rack portion, the inter-rack portion movement apparatus then moves the first article placed on the first rack portion to the second rack portion. After this, the internal movement apparatus moves the first article placed on the second rack portion to another rack portion. Then, the inter-rack portion movement apparatus moves the second article placed on the first rack portion to the second rack portion. Thus, as soon as the article is placed on the rack portion at the entrance, that article is transferred to the first rack portion. This allows the next article that is to be loaded from the loading port to be readied. Consequently, the article is moved quickly from the loading port to the second rack portion via the first rack portion, so the article spends less time supported at the loading port, or in other words, the transporting carriage spends less time stopped at the loading position.

The inter-rack portion movement apparatus is constituted separately from the internal movement apparatus, but there are no particular restrictions as long as article can be moved between the first rack portion and the second rack portion, and this apparatus may have the same constitution as the internal movement apparatus. Also, there are no particular restrictions on the in-out movement apparatus as long as article can be moved between the loading port and the first rack portion, and this apparatus may have the same constitution as the internal movement apparatus and/or the inter-rack portion movement apparatus.

As discussed above, at least two rack portions capable of temporarily storing articles moved from the loading port into the storage container are provided, and regardless of whether or not the article has been placed on the first rack portion, the first rack portion can be emptied by moving that article out of the way to the second rack portion. Consequently, continuous loading from the loading port can be carried out efficiently regardless of the operating state of the internal movement apparatus.

The in-out movement apparatus may have a first placement component having a first placement face arranged to support the article from the bottom side thereof, and first movement component that is able to move the first placement component between the loading port and the first rack portion. The inter-rack portion movement apparatus may have a second placement component having a second placement face arranged to support the article from the bottom side thereof, and a second movement component configured to move the second placement component between the first rack portion and the second rack portion. The loading port, the first rack portion, and the second rack portion each have a support component that is arranged to support a portion of the article different from the portion of the article supported by the first placement component or the second placement component.

With this mode, for example, the first placement component or second placement component and the support components of the loading port, first rack portion, and second rack portion are constituted so as to support different portions at the bottom face of the article, and the article can be supported with one or the other. Therefore, the article supported by the support component of the loading port is raised by the first placement component of the in-out movement apparatus, moved above the support component of the first rack portion, and finally lowered and placed on the support component of the first rack portion. Furthermore, the article supported by the support component of the first rack portion is raised by the second placement component of the inter-rack portion movement apparatus, moved above the support component of the second rack portion, and finally lowered and placed on the support component of the second rack portion.

As discussed above, article can be moved between the loading port and the first rack portion by the in-out movement apparatus, and can be transferred between the first rack portion and the second rack portion by the inter-rack portion movement apparatus.

The storage container further comprises a controller with which, when a plurality of articles are loaded into the storage container, the controller controls the in-out movement apparatus so that a first article placed onto the loading port from a first transporting carriage is moved from the loading port onto the first rack portion, then controls the inter-rack portion movement apparatus so that the first article is moved from the first rack portion to the second rack portion, and then controls the in-out movement apparatus so that a second article placed onto the loading port from a second transporting carriage is moved from the loading port onto the first rack portion.

With this mode, the in-out movement apparatus and the inter-rack portion movement apparatus are controlled in an orderly fashion, and a first article and a second article can be loaded continuously and efficiently.

The distance between the support component of the loading port and the lower face of the transporting carriage stopped at the loading position may be less than the height of one article.

With this mode, more precisely, if the distance between the support component of the loading port and the lower face of the transporting carriage located at the loading position is set to be less than the height of one article, at least the upper part of the article will not be exposed outside the transporting carriage during transfer between the loading port and the transporting carriage. Consequently, little if any lowering of the position is needed in the vertical direction at the loading port as compared to before the article becomes larger. Therefore, larger article can be accommodated while maintaining the safe height at the loading port.

The loading port has a positioning structure that positions the article placed on the loading port, and the transporting carriage may have a main body having an opening that opens to allow the passage of the article moved horizontally by the in-out movement apparatus when the transporting carriage is stopped at the loading position, a holder configured to hold the article in the main body, and an elevator configured to go up and down so as to shift the article held by the holder between a set position set by the positioning structure and a released position where the article is released from said set position.

With this configuration, utilizing a positioning structure allows loading and unloading to be carried out more efficiently as follows. The "positioning structure" referred to here is a plurality of positioning pins or other such convex components provided to the upper face of the loading port, and means a specific transfer position in transferring the article between the loading port and the transporting carriage. For example, the convex components may be able to engage with concave components provided to the bottom face of the article. More specifically, for example, when article is to be loaded, the article that is to be loaded by is held by a gripper or other such holder in the transporting carriage stopped at the loading position, and the article and the holder are lowered by a hoist or other such elevator and placed on the loading port. The article is positioned at the set position here. The "set position" here indicates a state in which concave components on the article side is engaged with convex components on the loading port side. The article at the set position is then moved by the in-out movement apparatus through the entrance to the rack portion adjacent to the entrance. Here, the article goes through the opening formed in the main body, and is moved from inside the transporting carriage to the side.
As discussed above, in the raising and lowering of the article in the loading operation, the elevator may raise or lower by the distance between the set position and the released position, that is, the distance corresponding to the length of the positioning structure in the vertical direction, which shortens the time it takes for loading and allows loading to be carried out more efficiently.

The action of the present invention and other benefits will be made clear from preferred embodiments given below.

### BRIEF DESCRIPTION OF DRAWINGS

FIG. 1 is an oblique view of a conveyance system comprising the storage container pertaining to a first embodiment;
FIG. 2 is a cross section in one direction schematically illustrating the internal structure of the storage container in FIG. 1;
FIG. 3 is a cross section in another direction schematically illustrating the internal structure of the storage container in FIG. 1;
FIG. 4 is an oblique view illustrating the operation of the rack portion shift apparatus in FIG. 3;
FIG. 5 is a flowchart of first continuous loading processing performed by the controller in FIG. 1;
FIG. 6 is a flowchart of first continuous loading processing performed by the controller in FIG. 1;
FIG. 7 is a cross section in another direction schematically illustrating the internal structure of the storage container pertaining to a second embodiment;
FIG. 8 is an oblique view illustrating the operation of the rack portion shift apparatus in FIG. 7;
FIG. 9 is a flowchart of second continuous loading processing pertaining to the second embodiment;
FIG. 10 is a flowchart of second continuous loading processing pertaining to the second embodiment; and
FIG. 11 is an oblique view of another example of the storage container pertaining to the present invention.

### DESCRIPTION OF EMBODIMENTS

### Assumed Configuration and Problems

With the storage container pertaining to the present invention, the loading and unloading of an article such as a FOUP are carried out by a transporting carriage such as an OHT (overhead hoist transport). The "transporting carriage" here is a ceiling-amounted vehicle, which travels along a rail or other such tracks installed on or near a ceiling for the loading and unloading of article, such as in a semiconductor element manufacturing plant or a facility used for the manufacture of semiconductor elements. More specifically, when loading an article, the transporting carriage holding the article to be loaded with a gripper or the like reaches a specific loading/unloading position on the track corresponding to the storage container, and stops there. A hoist or the like is then used to lower the gripper, etc., and the article, which is held by this gripper and is to be loaded, in the vertical direction, and the article is placed onto a loading port for taking articles in and out of the storage container. The article that is to be loaded is then released by the gripper, etc. After this, the released article moves into the storage container. Consequently, the transporting carriage enters a state where travel is possible, and the loading of the article by the transporting carriage is completed.

Meanwhile, when unloading an article, an empty transporting carriage reaches the above-mentioned loading/unloading position and stops there. After this, the article that is to be unloaded from the storage container moves to the loading port located beneath the transporting carriage, The above-mentioned hoist or the like is then used to lower the above-mentioned gripper or the like in the vertical direction, and the article that is to be unloaded and is resting on the loading port is held by the gripper or the like on the transporting carriage side. The hoist or the like then raises the gripper or the like and the article that is to be unloaded and is held by the gripper. Consequently, the transporting carriage enters a state where travel is possible, and the unloading of the article by the transporting carriage is completed.

When viewed from the outside, this storage container includes a housing or frame, and a plurality of rack portions are arranged inside this housing or frame. The "plurality of rack portions" here indicates rows of racks having a plurality of placement faces arranged in one or more rows in the vertical direction. For example, there may be *m* levels in the vertical direction (*where m* is a natural number of 2 or more), *n* rows in one horizontal direction (where *n* is a natural number of 1 or more), and *o* rows in the other horizontal direction that is perpendicular to the first horizontal direction (hereinafter referred to simply as the "thickness direction") (where *o* is a natural number of 1 or more), resulting in a flat shape that is thin and laterally slender. This constitutes the skeleton of the racks overall. The article that is loaded by transporting carriage into this storage container is moved horizontally by an in-out movement apparatus (such as a roller mechanism or a conveyor mechanism), typically through two entrances provided for loading and unloading, to the rack portion that is adjacent to the entrance, among the plurality of rack portions. An internal movement apparatus (known as a stocker) that serves as a transport apparatus within the storage container, such as a robotic arm, then moves, for example, in the vertical direction and one horizontal direction (that is, in two directions, or biaxially) between the plurality of rack portions, and the article at the rack portion adjacent to the entrance is moved to another rack portion. In other words, the article that has been conveyed and loaded into the storage container is held or stored in that storage container.

If a plurality of articles are continuously loaded into the storage container from a plurality of transporting carriages, one of the transporting carriages typically stops at the loading/unloading position, and a first article is placed onto the loading port. The empty transporting carriage begins to travel away from the loading/unloading position before or after the first article moves horizontally from the loading port into the storage container. A second transporting carriage then stops at the loading/unloading position, and a second article is placed onto the loading port. The empty transporting carriage then begins to travel away from the loading/unloading position before or after the second article moves horizontally from the loading port into the storage container. Assuming that nothing special is performed, this continuous loading takes longer as the article is supported on the loading port for a longer period of time, or in other words, it takes longer for a transporting carriage to stop at the loading/unloading position for loading, and the continuous loading ends up being inefficient.

Embodiments of the present invention will now be described through reference to the drawings.

### First Embodiment

### Configuration of First Embodiment

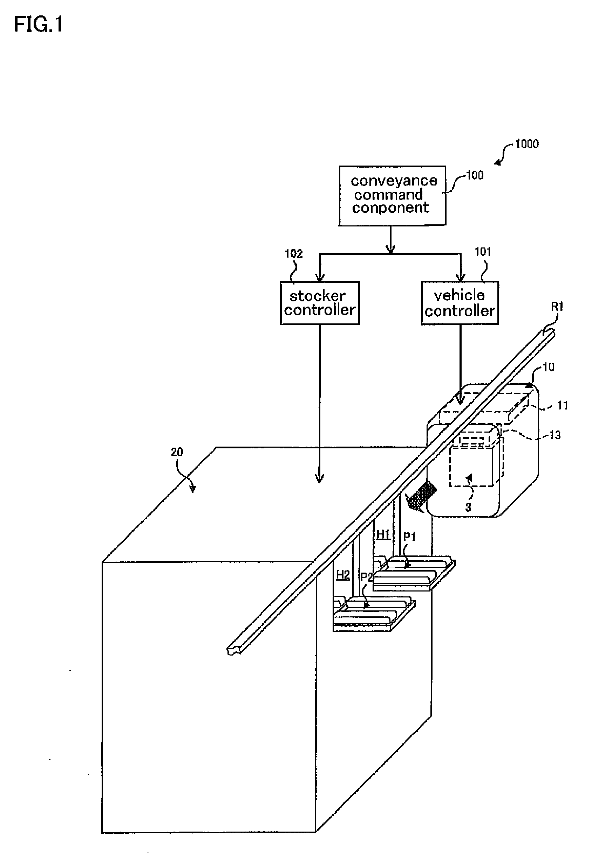

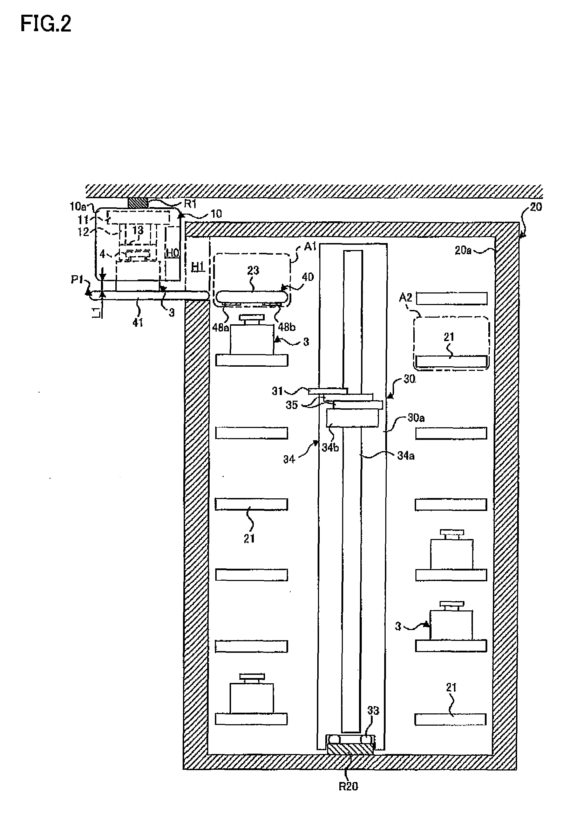

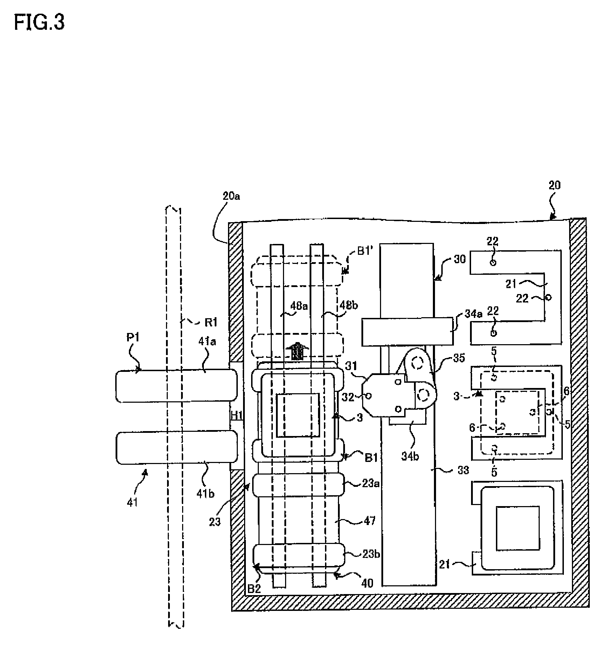

The configuration of the storage container pertaining to a first embodiment of the present invention will be described with reference to FIGS. 1 to 3. FIG. 1 is an oblique view of a conveyance system comprising the storage container pertaining to the first embodiment. FIG. 2 is a cross section view in one direction, schematically illustrating the internal structure of the storage container in FIG. 1, in which the storage container in FIG. 1 has been cut along the longitudinal direction (this is called the "first direction"). FIG. 3 is a cross section view in another direction, schematically illustrating the operation of the rack portion shift apparatus in FIG. 2, in which the upper face of the storage container in FIG. 1 has been cut along a horizontal plane,

In FIG. 1, a conveyance system 1000 comprises a rail R1, a vehicle 10, a stocker 20, and, as a control system, a conveyance command component 100, a vehicle controller 101, and a stocker controller 102. According to a conveyance schedule for manufacturing semiconductor elements, the conveyance system 1000 conveys a FOUP 3 to various manufacturing equipment, the stocker 20, and so forth, and also holds or stores the FOUP 3 in the stocker 20.

The FOUP 3 serves as an example of the "article" pertaining to the present invention. The FOUP 3 is conveyed by the vehicle 10 along the rail R1, and is conveyed for loading or unloading, or for storage position adjustment (that is, it is conveyed within the storage container). The FOUP 3 has on its upper face a flange 4 that is to be gripped by the vehicle 10 and an automatic conveyance apparatus 30 (discussed below). As shown in FIG. 3, the FOUP 3 has a plurality of concave components 5 and 6 in the center and side portions of its lower face. The concave components 5 located on the side portion of the lower face are formed in a size corresponding to convex components on a plurality of rack portions 21 and 23 and ports P1 and P2 (discussed below). Meanwhile, the concave components 6 located in the center part of the lower face are formed in a size corresponding to convex components 32 provided on a placement component 31 (discussed below).

The rail R1 is an example of the "track" pertaining to the present invention. The rail R1 is installed on the ceiling of a semiconductor element manufacturing facility, and serves as a track on which the vehicle 10 travels. Various manufacturing equipment, the stocker 20, and so forth are installed at positions adjacent to and below the rail R1. The portion of the rail R1 located directly above the ports P1 and P2 is set as the loading/unloading position.

In FIG. 2, the vehicle 10 is an OHT (overhead transport) which utilizes a linear motor as its power source, travels along the rail R1, conveys the FOUP 3, stops at the loading/unloading position on the rail R1, and is able to transfer the FOUP 3 between respective ports (such as the port P1) of the various manufacturing equipment, the stocker 20, and so forth. The vehicle 10 comprises a main body 10a, a hoist 11, a belt 12, and a gripper 13. These components are controlled by the vehicle controller 101.

The main body 10a has within itself a space in which the entire FOUP 3 can be accommodated. This space is open downward and at least to another (or one more) side (more specifically, the right side of the main body 10a in FIG. 2). Specifically, with the main body 10a, an opening located under the space is formed in a size that allows the FOUP 3 held inside the main body 10a to be raised and lowered in the vertical direction. Also, an opening H0 located to the side of the space is formed in a size that allows the FOUP 3 placed on ports P1 and P2 to be moved horizontally to the above-mentioned side.

The hoist 11 is attached in the vehicle 10. The hoist 11 is an example of the "elevator" pertaining to the present invention along with the belt 12, is driven by an actuator or a motor, and can wind the belt 12 up or down. The belt 12 is fixed at one end to the hoist 11, and at the other end to the gripper 13. The gripper 13 is an example of the "holding apparatus" pertaining to the present invention, is driven by an actuator or a motor, and can shift between a held state in which the FOUP 3 is held by gripping the flange 4 and a released state in which the FOUP 3 (in other words, the flange 4) is released.

The hoist 11 raises and lowers the gripper 13 by winding the belt 12 up or down. The elevating distance of this gripper 13 (in other words, the FOUP 3) shall be a distance obtained by adding a small allowance to the length of the positioning pins when the positioning pins (an example of the positioning apparatus pertaining to the present invention) are provided to the ports P1 and P2, for example.

The stocker 20 is an example of the "first storage container" pertaining to the present invention, and can hold or store a plurality of FOUPs 3 conveyed by the vehicle 10. The stocker 20 comprises a main body 20a, the ports P1 and P2, the plurality of rack portions 21 and 23, the automatic conveyance apparatus 30, and a buffer apparatus 40.

Two openings H1 and H2 used for loading and unloading are provided at the main body 20a (specifically, an example of the "housing or frame" pertaining to the present invention), on the side face towards the rail R1 side (that is, the right face in FIG. 1). The two openings H1 and H2 (examples of the "entrance" pertaining to the present invention) are adjacent to the ports P1 and P2, and are formed between the interior of the main body 20a and the ports P1 and P2, in a size that allows the FOUP 3 to be taken into and out of the main body 20a. The plurality of rack portions 21 and 23, the automatic conveyance apparatus 30, and the buffer apparatus 40 are arranged inside the main body 20a. In this embodiment, out of the two openings H1 and H2 of the stocker 20, the configuration and operation of the opening H1 are described in detail, and the configuration and operation of the other opening H2, which are the same as those of the opening H1, will be omitted.

The port P1 is an example of the "loading port" pertaining to the present invention, is adjacent to the opening H1 to the outside towards the rail R1 side of the main body 20a, and is provided vertically below the rail R1 so that the FOUP 3 can be transferred between the vehicle 10 and the stocker 20. The port P1 comprises a conveyor 41 capable of moving horizontally the FOUP 3 transferred from the vehicle 10, through the opening H1, toward the interior of the main body 20a.

The conveyor 41 functions as part of the "in-out movement apparatus" pertaining to the present invention, is driven by an actuator or a motor, and is configured so as to move the FOUP 3 on the port P1 horizontally over one of the plurality of rack portions 21 and 23 which is adjacent to the opening H1 (that is, the one located in area A1 indicated by the two-dot chain line in FIG. 2). The conveyor 41 includes a pair of conveyor portions 41a and 41b, each having a placement face capable of supporting the side of the lower face of the FOUP 3. These placement faces are each set at a height that is a distance L1 (see FIG. 2) vertically below the lower face of the vehicle 2 stopped at the loading/unloading position. The distance L1 is less than the height of one FOUP 3.

With the plurality of rack portions 21 and 23, there are seven levels in the vertical direction, three rows in one horizontal direction (that is, the longitudinal direction in FIG. 1) at each level, and two rows in the thickness direction (that is, the left and right direction in FIG. 1) at each level, so that a total of 42 rack portions can be put in place. In this embodiment, for the one row on the opening H1 side out of the two rows in the thickness direction (that is, the left and right direction in FIG. 1) at the highest level, the number of rows in one horizontal direction (that is, the up and down direction in FIG. 3) is reduced from the normally three rows into two. In other words, the plurality of rack portions 21 and 23 include a total of 41 rack portions.

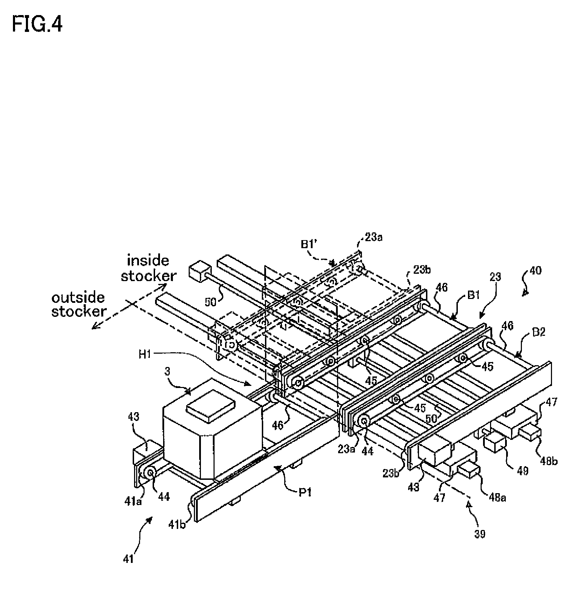

In FIG. 3, among the plurality of rack portions 21 and 23, the two rack portions on the opening H1 side at the above-mentioned highest level are examples of the "first rack portion" and "second rack portion" pertaining to the present invention, are linked to each other by a linking component 47 (FIGS. 3 and 4), and constitute a movable rack portion 23. The movable rack portion 23 is driven by a shift mechanism (discussed below), and is able to move in a direction parallel to the orientation of the rail R1 (that is, one horizontal direction). The movable rack portion 23 has a first buffer B1 and a second buffer B2. The first buffer 1 and the second buffer B2 are arranged in a direction parallel to the direction in which the rail R1 extends near the opening H1. The first buffer B1 and the second buffer B2 have conveyor belts 23a and 23b, which are a pair of placement components each having a placement face that is able to support the side portion of the lower face of a FOUP 3.

Meanwhile, the other rack portions 21 of the plurality of rack portions 21 and 23 are fixed, and each has a placement face that can support the side portion of the lower face of a FOUP 3 This placement face is made up of a first straight part and a pair of second straight parts extending in one direction from both sides of the first straight part. Convex components 22 are provided on each placement face. The convex components 22 are formed in a size that allows engagement with the concave components 5 formed on the side portion of the lower face of the FOUP 3.

The automatic conveyance apparatus 30 is an example of the "internal movement apparatus" pertaining to the present invention, and is a stocker (or stocker robot) serving as an intra-storage container conveyance apparatus that can automatically convey the FOUP 3 between the plurality of rack portions 21 and 23 under the control of the stocker controller 102. The automatic conveyance apparatus 30 comprises the placement component 31, a main body 30a, a vertical guide 34, and a horizontally extending turning arm (hereinafter sometimes referred to simply as "arm") 35. A plurality of rollers 33 serving as a sliding guide, the vertical guide 34, and the horizontally extending turning arm 35 are controlled by the stocker controller 102.

With the drive by the plurality of rollers 33 in one horizontal direction, the drive by the vertical guide 34 in the vertical direction, and the drive by the arm 35 in the thickness direction, the placement component 31 is able to move back and forth between the plurality of rack portions 21 and 23. The placement component 31 has a placement face (that is, an example of the "first placement face" pertaining to the present invention) that can support the center part of the lower face of a FOUP 3. In FIG. 3, the placement component 31 has the convex components 32 on its placement face. The convex components 32 are formed in a size corresponding to the concave components 6 formed in the center part of the lower face of the FOUP 3, and are engaged with these concave components 6 during transfer of the FOUP 3.

The plurality of rollers 33 are driven by an actuator or a motor, and are attached to the bottom face of the main body 30a so that they can rotate on a rail R20 installed on the floor inside the stocker 20. The vertical guide 34 is fixed in the up and down direction to the main body 30a. The main body 30a is configured so that the vertical guide 34 (in other words, the placement component 31) can be moved in one horizontal direction with the rotation of the plurality of rollers 33.

The arm 35 is attached to the vertical guide 34 in a way so as to be movable in just the vertical direction. The vertical guide 34 is made up of a mechanism 34a that is rotatable about the vertical direction by an actuator or a motor, and a rotary component 34b that is fixed to the rotating portion of this mechanism 34a. The vertical guide 34 is configured so that the arm 35 (in other words, the placement component 31) attached turnably to the upper face of the rotary component 34b can move back and forth in the vertical direction, according to the action of the mechanism 34a.

The placement component 31 is attached to the arm 35 in a way so as to be movable in just the thickness direction. The arm 35 is made up of two arm components linked in the up and down direction. These two arm components are turned relative to each other by an actuator (such as a hydraulic cylinder) or a motor, so that they can be extended in the thickness direction. The arm 35 is configured so that the placement component 31 fixed to the upper arm component (of the two arm components) is able to move back and forth in the thickness direction.

The buffer apparatus 40 is used to temporarily place article that has been conveyed to the loading/unloading port P1, near the opening H1 inside the main body 20a. The buffer apparatus 40 comprises the movable rack portion 23 and a shift mechanism 39, which is an example of the "rack portion shift apparatus" pertaining to the present invention.

Next, the shift mechanism 39 of the buffer apparatus 40 will be described in detail with reference to FIG. 4. FIG. 4 is an oblique view showing in detail how the buffer apparatus 40 in FIG. 3 looks.

In FIG. 4, the shift mechanism 39 is composed of a shift guide 48, a motor 49, and a ball screw 50, and the motor 49 is controlled by the stocker controller 102.

The shift guide 48, which is provided in one horizontal direction, is fitted into the lower part of the linking component 47. More specifically, a first shift guide 48a and a second shift guide 48b are provided respectively for a pair of linking components 47. Also, the ball screw 50, which is rotated by the drive of the motor, is attached to the linking components 47. The linking components 47 are moved back and forth in one horizontal direction along the shift guide 48 with the rotation of this ball screw 50, and are configured such that either the first buffer B1 or the second buffer B2 is disposed at a position adjacent to the opening H1.

With the above-mentioned shift mechanism 39, the first buffer B1 or the second buffer B2 disposed at the position adjacent to the opening H1 functions as part of the "in-out movement apparatus" pertaining to the present invention, and is configured so that the FOUP 3 on each placement face can move horizontally onto the port P1. The configuration of the first buffer B1 and second buffer B2 will now be described.

The first buffer B1 and the second buffer B2 include a pair of conveyor belts 23a and 23b that are able to support the side portion of the lower face of the FOUP 3, a motor 43 (serves as the drive source), a drive roller 44 that is rotated with the drive of the motor 43, an auxiliary roller 45 that rotates the conveyor belt 23a along with the drive roller 44, and a transmission shaft 46 that transmits the rotation of the conveyor belt 23a to the other conveyor belt 23b. In this embodiment, the above-mentioned conveyor 41 is configured so that the FOUP 3 above the port P1 moves onto the rack portion (the first buffer B1 or the second buffer B2) adjacent to the opening H1.

Also, in FIG. 1, the conveyance command component 100 is an MCS (material control system) that produces a FOUP 3 conveyance schedule on the basis of a semiconductor element manufacturing schedule stored in a manufacturing command component (serves as a main controller), and that is configured so that the vehicle controller 101 and the stocker controller 102 can be controlled on the basis of this conveyance schedule. The conveyance command component 100 is configured so as to be able to command the vehicle controller 101 to convey the FOUP 3 with the vehicle 10, and to command the stocker controller 102 to convey the FOUP 3 within the stocker 20.

The vehicle controller 101 controls the various components of the vehicle 10 under the command from the conveyance command component 100, executes the transfer of the FOUP 3 along the rail R1, and is able to execute the conveyance of the FOUP 3 between the various manufacturing equipment, the stocker 20, and so forth.

The stocker controller 102 controls the various components of the automatic conveyance apparatus 30 and the port P1 under the command from the conveyance command component 100, executes the conveyance (that is, the loading and unloading) of the FOUP 3 to and from the vehicle 10 via the port P1, controls the various components of the automatic conveyance apparatus 30, and is able to execute the conveyance (that is, the conveyance within the storage container) of the FOUP 3 within the stocker 20. Also, the stocker controller 102 is an example of the "controller" pertaining to the present invention, controls the various components of the buffer apparatus 40, and is able to execute first continuous loading processing and first continuous unloading processing (discussed below) in order to handle continuous loading and unloading. Specifically, the FOUP 3 is temporarily held or stored with the movable rack portion 23 (serves as a buffer inside the storage container) during the above-mentioned loading or unloading and conveyance within the storage container.

### Operation of First Embodiment

### First Continuous Loading Processing

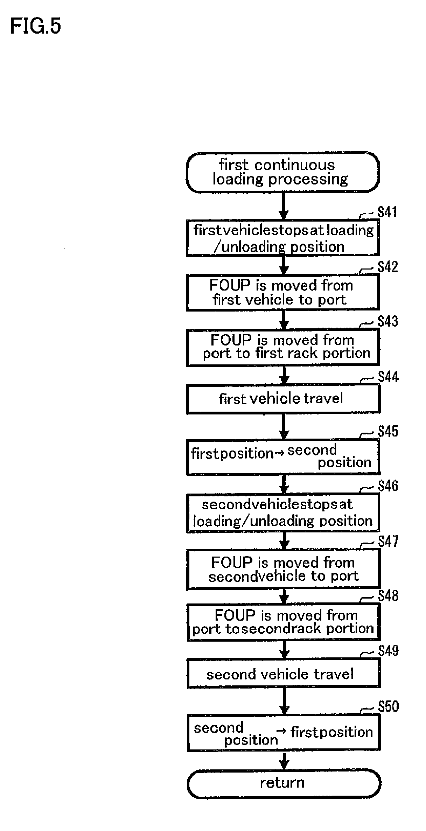

Next, first continuous loading processing by the stocker controller 102 will be described, again referring to FIGS. 4 and 5. FIG. 5 here is a flowchart of the first continuous loading processing. In this first continuous loading processing, the operation is shown in which first a FOUP 3 is loaded by a vehicle 10, after which a second FOUP 3 is loaded by a second vehicle 10. Also, it is assumed an initial state in which the movable rack portion 23 is in a first position. In the first position, the empty first buffer B1 is positioned adjacent to the opening H1 so as to be able to support the FOUP 3 that is to be loaded first.

In FIG. 5, the first vehicle 10 stops at the loading/unloading position under the control of the vehicle controller 101 (step S41). Then, the first FOUP 3 held in the first vehicle 10 is lowered to a height at which the lower face of the FOUP 3 comes into contact with the placement face of the conveyor 41, and the first FOUP 3 is released from the gripper 13 and thereby transferred to the port P1 (step S42). Here, the upper part of the FOUP 3 is not exposed under the vehicle 10. Next, the conveyor 41 is rotated under the control of the stocker controller 102, and the first FOUP 3 on the port P1 is moved through the opening H0 of the vehicle 10 and the opening H1 of the stocker 20 onto the first buffer B1 in FIG. 4 (step S43). After this, the first vehicle 10 travels to the next conveyance destination under the control of the vehicle controller 101 (step S44). Then, the motor 49 is driven under the control of the stocker controller 102, and the movable rack portion 23 is moved from the first position to the second position. In the second position, the empty second buffer B2 is positioned adjacent to the opening H1 so as to be able to support the second FOUP 3 that is to be loaded next (step S45). The operation in step S45 may be carried out in parallel with the operation in step S44, or may be carried out prior to step S44.

Then, the second vehicle 10 stops at the loading/unloading position under the control of the vehicle controller 101 (step S46). Then, the second FOUP 3 held in the second vehicle 10 is moved onto the port P1 (step S47), and the second FOUP 3 on the port P1 is moved under the control of the stocker controller 102 onto the second buffer B2 adjacent to the opening H1 (step S48). After this, the second vehicle 10 travels toward the next conveyance destination under the control of the vehicle controller 101 (step S49). Then, the movable rack portion 23 is moved from the second position back to the first position under the control of the stocker controller 102 (step S50). This ends one cycle of the first continuous loading processing.

### First Continuous Unloading Processing

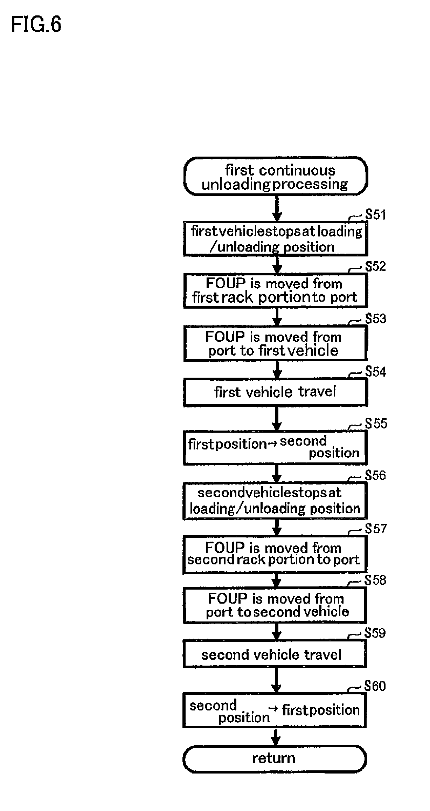

Next, the first continuous unloading processing performed by the stocker controller 102 will be described again referring to FIGS. 4 and 6. FIG. 6 is a flowchart of the first continuous unloading processing. In this first continuous unloading processing, the operation is shown in which a first FOUP 3 is unloaded by a first vehicle 10, after which a second FOUP 3 is unloaded by a second vehicle 10. Also, it is assumed an initial state in which the movable rack portion 23 is in a first position. In the first position, the first buffer B1 supporting the FOUP 3 to be unloaded first is adjacent to the opening H1.

In FIG. 6, the first vehicle 10 stops at the loading/unloading position under the control of the vehicle controller 101 (step S51). Then, the conveyor belts 23a and 23b of the first buffer B1 are rotated under the control of the stocker controller 102, and the first FOUP 3 on the first buffer B1 is moved through the opening H1 of the stocker 20 and the opening H0 of the vehicle 10 onto the port P1 (step S52). Then, the first FOUP 3 on the port P1 is held by the gripper 13 under the control of the vehicle controller 101, and the first FOUP 3 is raised to a height at which the lower face of the FOUP 3 is not in contact with the placement face of the conveyor 41, thereby transferring the FOUP 3 to the first vehicle 10 (step S53). After this, the first vehicle 10 travels toward the next conveyance destination (step S54). Then, the motor 49 is driven under the control of the stocker controller 102, and the movable rack portion 23 is moved from the first position to the second position (step S55). In the second position, the second buffer B2 supporting the second FOUP 3 to be unloaded next is adjacent to the opening H1. The operation in step S55 may be carried out in parallel with the operation in step S53 or S54, or may be carried out prior to steps S53 and S54.

Then, the second vehicle 10 stops at the loading/unloading position under the control of the vehicle controller 101 (step S56). Then, the second FOUP 3 on the second buffer B2 is moved onto the port P1 under the control of the stocker controller 102 (step S57). Then, the second FOUP 3 on the port P1 is transferred to the second vehicle 10 (step S58). After this, the second vehicle 10 travels toward the next conveyance destination (step S59). Then, the movable rack portion 23 is moved under the control of the stocker controller 102 from the second position to the first position and back into the initial state (step S60). This ends one cycle of the first continuous unloading processing.

As discussed above, with the first continuous loading processing of this embodiment, the first buffer B1 and the second buffer B2 (at least two) are provided, which allow temporary placement of the FOUP 3 moved from the port P1 into the stocker 20. And, during each loading, the first buffer B1 and the second buffer B2 are alternately adjacent to the opening H1. Consequently, continuous loading from the port P1 can be performed efficiently regardless of the operating state of the automatic conveyance apparatus 30. The same applies to unloading processing.

Also, during the first continuous loading processing and the first continuous unloading processing of this embodiment, the distance L1 in the vertical direction between the port P1 and the vehicle 10 stopped at the loading/unloading position is made less than the height of one FOUP 3, so at least the upper part of the FOUP 3 is not exposed during transfer. Consequently, the disposition of the port P1 in the vertical direction is no lower as compared to that in the case before the article becomes larger. Therefore, a larger FOUP 3 can be accommodated while maintaining the safe height.

### Features of First Embodiment

The features of the first embodiment described above are as follows. The stocker 20 performs the loading of FOUPs 3 to and from the vehicles 10 that convey the FOUPs 3 and travel along the rail R1 provided to the ceiling. The stocker 20 comprises the main body 20a, the port P1, the automatic conveyance apparatus 30, the rack portions 21, the movable rack portion 23, the shift mechanism 39, and the conveyor 41. The main body 20a has a plurality of levels arranged in the vertical direction, and has at least one opening H1 provided to correspond to at least one of these levels. The port P1 is adjacent to the opening H1 on the outside of the main body 20a, and allows the FOUP 3 to be put in place. The automatic conveyance apparatus 30 is able to move the FOUP 3 in at least one horizontal direction and in the vertical direction within the main body 20a. The plurality of rack portions 21 are arranged in at least one horizontal direction at each of the plurality of levels within the main body 20a, and are configured to allow the placement of the FOUPs 3 moved by the automatic conveyance apparatus 30. The movable rack portion 23 has the first buffer B1 and the second buffer B2 that are linked to each other, and is able to move. The shift mechanism 39 is able to shift the movable rack portion 23 between the first position, where the first buffer B1 is adjacent to the opening H1, and the second position, where the second buffer B2 is adjacent to the opening H1. The conveyor 41 is able to move the FOUP 3, via the opening H1, between the port P1 and the first buffer B1 or second buffer B2 at the position adjacent to the opening H1.

For example, after the conveyor 41 moves the first FOUP 3 from the loading port to the first buffer B1 adjacent to the opening H1, the shift mechanism 39 shifts the movable rack portion 23 from the first position to the second position. As a result, the second buffer B2, on which no FOUP 3 has been placed, is adjacent to the opening H1, rather than the first buffer B1. After this, the automatic conveyance apparatus 30 moves the first FOUP 3 placed on the first buffer B1 to the rack portion 21, either before or after the conveyor 41 moves the second FOUP 3 from the port P1 to the second buffer B2. The shift mechanism 39 then shifts the movable rack portion 23 from the second position to the first position. As a result, the empty first buffer B1 is adjacent to the opening H1, instead of the second buffer B2. Thus, as soon as the FOUP 3 is placed on the rack portion adjacent to the opening H1, the rack portion on which the FOUP 3 has been placed is retracted, and in its place a rack portion on which a FOUP 3 has not been placed is brought adjacent to the opening H1, where it awaits the next FOUP 3 to be loaded from the port P1. Consequently, the FOUP 3 can be quickly moved from the port P1 to the movable rack portion 23, and the FOUP 3 spends less time at the port P1. Or in other words, the vehicle 10 spends less time at the loading position.

As mentioned above, at least two rack portions (i.e. intra-storage container buffers) are provided to allow the temporary placement of a FOUP 3 that has been moved from the port P1 into the stocker 20, and the two rack portions are alternately adjacent to the opening H1 during loading. Consequently, continuous loading from the port P1 can be carried out efficiently regardless of the operating state of the automatic conveyance apparatus 30.

The first buffer B1 and the second buffer B2 are linked and aligned in a direction parallel to the direction in which the rail R1 extends near the opening H1, and the shift mechanism 39 is able to move the movable rack portion 23 in a direction parallel direction thereto.

With this mode, when the movable rack portion 23 is shifted alternately between the first position and second position by the shift mechanism 39, the distance of such movement is the width of one rack portion, for example, in a direction parallel to the direction in which the rail R1 extends. Consequently, the rack portion adjacent to the opening H1 can be changed extremely quickly.

When a plurality of FOUPs 3 are to be loaded into the stocker 20, the stocker controller 102 further controls the conveyor 41 such that the first FOUP 3 placed from the first vehicle 10 onto the port P1 is moved from the port P1 to the first buffer B1, and then controls the shift: mechanism 39 so that the movable rack portion 23 is shifted from the first position to the second position, and then controls the conveyor 41 such that the second FOUP 3 placed from the second vehicle 10 onto the port P1 is moved from the port P1 to the second buffer B2.

With this mode, the conveyor 41 and the shift mechanism 39 are controlled in an orderly fashion, and the first FOUP 3 and the second FOUP 3 can be continuously and efficiently loaded.

### Second Embodiment

### Configuration of Second Embodiment

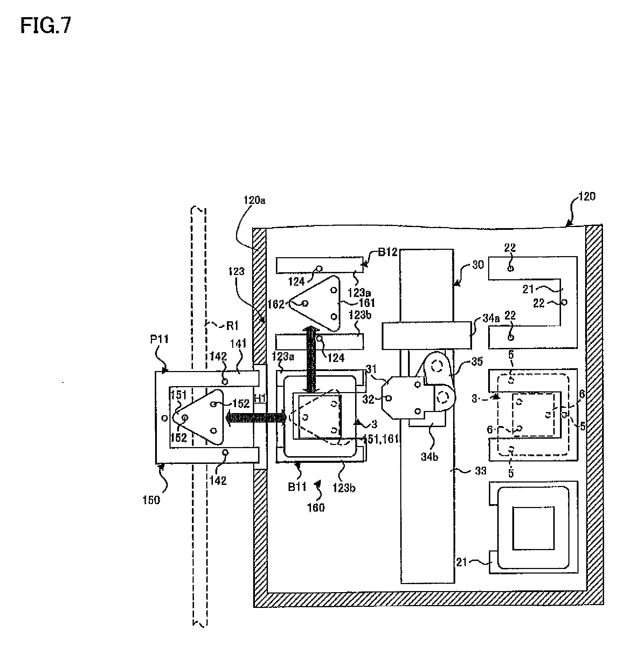

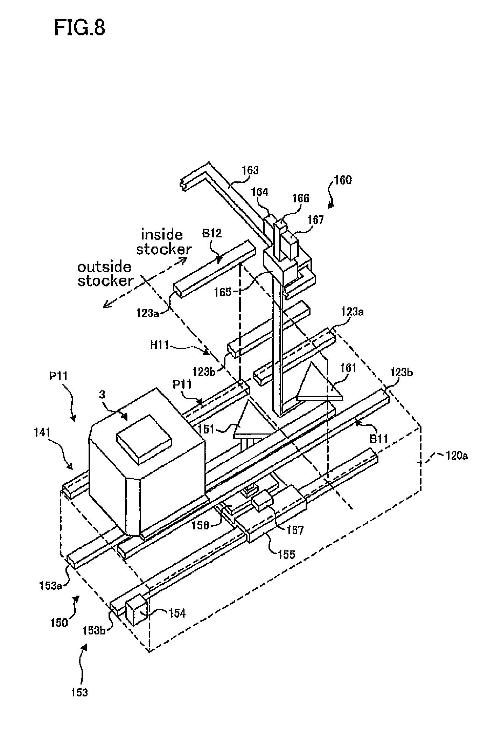

Next, the configuration of the storage container pertaining to a second embodiment of the present invention will be described with reference to FIGS. 7 and 8. FIG. 7 is a cross section view in another direction schematically illustrating the internal structure of the storage container pertaining to the second embodiment, and FIG. 8 is an oblique view illustrating in detail the in-out movement apparatus and the inter-rack portion movement apparatus pertaining to the second embodiment. In this second embodiment, those elements that are configured the same as those in the first embodiment will be numbered the same and may not be described again.

In FIG. 7, a stocker 120 is an example of the "second storage container" pertaining to the present invention, and comprises an inter-port movement apparatus 150 and an inter-buffer movement apparatus 160 in addition to a main body 120a, a port P1, a plurality of rack portions 21 and 123, and an automatic conveyance apparatus 30.
In this embodiment, the rack portion 123 is a buffer adjacent to the opening H1, and is composed of a first buffer B11 and a second buffer B12. The first buffer B11 is adjacent to an opening H11, and the second buffer B12 is arranged in a direction parallel to the direction in which the rail R1 extends near the opening H1, with respect to the first buffer B11. In this embodiment, the first buffer B11 and the second buffer B12 are fixed to the main body 120a.

The inter-port movement apparatus 150 is an example of the "in-out movement apparatus" pertaining to the present invention, and is configured so as to be able to move a FOUP 3 between a port P11 and the first buffer B11. The inter-port movement apparatus 150 comprises a first arm 151 that can support the center part of the lower face of the FOUP 3, and a movement component (discussed below).

In FIG. 8, the movement component of the inter-port movement apparatus 150 is composed of a lateral guide 153, a lateral motor 154, a main body 155, an elevator 156, and an elevator motor 157. The lateral motor 154 and the elevator motor 157 are controlled by a stocker controller.

The lateral guide 153 is fitted into the lower part of the main body 155. The lateral guide 153 is installed below the port P11 and arranged in the thickness direction, and includes a conveyor that is rotatable in the thickness direction by the lateral motor 154. More precisely, the lateral guide 153 is composed of a first lateral guide 153a and a second lateral guide 153b. The main body 155 is configured so that the first arm 151 can be moved back and forth in the thickness direction with the rotation of this conveyor. The elevator 156 is attached to the upper face of the main body 155 in a way so as to be movable in only the vertical direction. The elevator 156 is configured so that it can be moved back and forth in the vertical direction by the elevator motor 157.

The inter-buffer movement apparatus 160 is an example of the "inter-rack portion movement apparatus" pertaining to the present invention, and is configured so as to be able to move the FOUP 3 between the first buffer B11 and the second buffer B12. The inter-buffer movement apparatus 160 comprises a second arm 161 that is the same as the first arm 151 of the inter-port movement apparatus 150, and a movement component that will be discussed below.

The movement component of the inter-buffer movement apparatus 160 is composed of a lateral guide 163, a lateral motor 164, a main body 165, an elevator guide 166, and an elevator motor 167. The lateral motor 164 and the elevator motor 167 are controlled by a stocker controller.

The lateral guide 163 is fitted into the main body 165. The lateral guide 163 is installed above the first buffer B11 and the second buffer B12 and arranged in one horizontal direction, and includes a roller that is rotatable in one horizontal direction by the lateral motor 164. The main body 165 is configured so that the second arm 161 can be moved back and forth in one horizontal direction with the rotation of this roller. The elevator guide 166 is installed in the vertical direction on the upper face of the main body 165. The elevator guide 166 includes a roller that is rotatable in the vertical direction by the elevator motor 167. The main body 165 is configured so that the second arm 161 can be moved back and forth in the vertical direction with the rotation of this roller.

The first arm 151 and the second arm 161, which are shared between the inter-port movement apparatus 150 and the inter-buffer movement apparatus 160, have triangular placement faces (that is, an example of the "first placement face" and "second placement face" pertaining to the present invention) capable of supporting the center part of the lower face of the FOUP 3. The first arm 151 and the second arm 161 have a plurality of convex components 152 and 162, respectively. The port P11, meanwhile, has a placement face 141 (that is, an example of the "support component" pertaining to the present invention) capable of supporting the side portion of the lower face of the FOUP 3. The placement face 141 is composed of a first straight component and a pair of second straight components extending in one direction from both sides of the first straight component. A plurality of convex components 142 are formed on the placement face 141. Also, each of the first buffer B11 and the second buffer B12, to which the inter-buffer movement apparatus 160 corresponds, includes a rectangular placement face (that is, an example of the "support component" pertaining to the present invention) capable of supporting the side portion of the lower face of a FOUP 3. The rectangular placement is composed of a pair of placement components 123a and 123b. Convex components 124 are formed on the placement components 123a and 123b. Specifically, the placement faces of the first arm 151 and the second arm 161, and the placement faces of the port P11 or the first buffer B11 and second buffer B12 have planar shapes complementary to each other. Transfer of FOUPs 3 is performed between these two placement faces.

### Operation of Second Embodiment

### Second Continuous Loading Processing

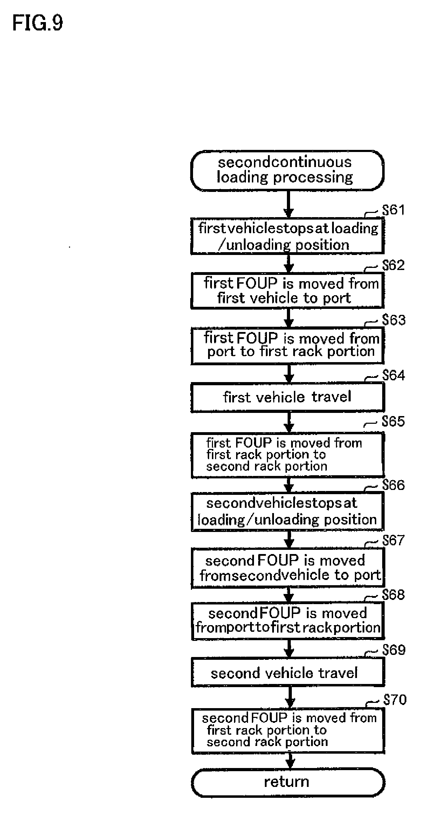

Next, second continuous loading processing performed by a stocker controller will be described, again with reference to FIGS. 8 and 9. FIG. 9 is a flowchart of the second continuous loading processing. In this second continuous loading processing, just as with the first continuous loading processing in FIG. 5, an operation is shown in which after a first FOUP 3 has been loaded from a first vehicle 10, a second FOUP 3 is loaded from a second vehicle 10. Also, it is assumed an initial state in which the first buffer B11 is empty so that it is able to support the first FOUP 3 to be loaded, and the second arm 161 of the inter-buffer movement apparatus 160 is positioned on the second buffer B12 side so as not to interfere with the movement of the first arm 151 of the inter-port movement apparatus 150.

In FIG. 9, the first vehicle 10 stops at the loading/unloading position under the control of the vehicle controller (step S61). Then, the first FOUP 3 held by the first vehicle 10 is lowered to a height at which its bottom face comes into contact with the placement face 141 of the port P11, and the first FOUP 3 is released from the gripper 13 and thereby transferred to the port P11 (step S62). Then, the first arm 151 is moved in the thickness direction and the vertical direction under the control of the vehicle controller, and is brought to the same height as the placement faces of the first buffer B11 and the port P11, based on which the first FOUP 3 on the port P11 is moved onto the first buffer B11 via the opening H0 of the vehicle 10 and the opening H11 of the stocker 120 (step S63). After this, the first vehicle 10 travels toward the next conveyance destination under the control of the vehicle controller (step S64). Then, the second arm 161 is moved in the thickness direction and the vertical direction under the control of the stocker controller, and is brought to the same height as the placement faces of the first buffer B11 and the second buffer B12, based on which the first FOUP 3 on the first buffer B11 is moved onto the second buffer B12 (step S65).

Then, the second vehicle 10 stops at the loading/unloading position under the control of the vehicle controller (step S66). Then, the second FOUP 3 held in the second vehicle 10 is transferred onto the port P11 (step S 67), and the second FOUP 3 on the port P11 is moved onto the first buffer B11 under the control of the stocker controller (step S68). After this, the second vehicle 10 travels to the next conveyance destination under the control of the vehicle controller (step S69). Then, the second FOUP 3 above the first buffer B11 is moved onto the second buffer B12 under the control of the stocker controller (step S70). This ends one cycle of the second continuous loading processing.

### Second Continuous Unloading Processing

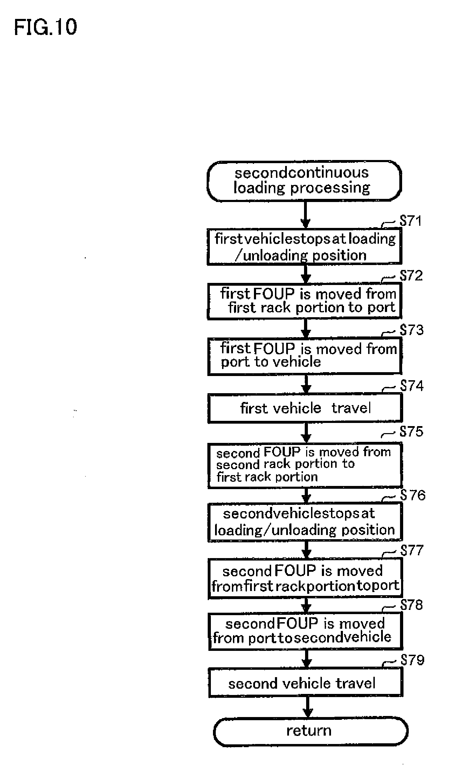

Next, the second continuous unloading processing performed by the stocker controller will be described, again with reference to FIGS. 8 and 10. FIG. 10 is a flowchart of the second continuous unloading processing. In this second continuous unloading processing, just as with the first continuous unloading processing in FIG. 6, an operation is shown in which a first FOUP 3 is unloaded by a first vehicle 10, after which a second FOUP 3 is unloaded by a second vehicle 10. Also, it is assumed an initial state in which the first buffer B11 supports the first FOUP 3 to be unloaded, and the second arm 161 of the inter-buffer movement apparatus 160 is positioned on the second buffer B12 side so as not to interfere with the movement of the first arm 151 of the inter-port movement apparatus 150.

In FIG. 10, the first vehicle 10 stops at the loading/unloading position under the control of the vehicle controller (step S71). Then, the first arm 151 is moved in the thickness direction and the vertical direction under the control of the stocker controller, and is brought to the same height as the placement faces of the first buffer B11 and the port P11, based on which the first FOUP 3 on the first buffer B11 is moved onto the port P11 (step S72). Then, the first FOUP 3 on the port P11 is held by the gripper 13 under the control of the vehicle controller, and is raised to a height at which the bottom face of the first FOUP 3 is not in contact with the placement face 141 of the port P1, and is thereby transferred to the first vehicle 10 (step S73). After this, the first vehicle 10 travels toward the next conveyance destination (step S74). Then, the second arm 161 is moved in the thickness direction and the vertical direction under the control of the stocker controller, and is brought to the same height as the placement faces of the second buffer B12 and the first buffer B11, based on which the second FOUP 3 on the second buffer B12 is moved onto the first buffer B11 (step S75).

Then, the second vehicle 10 stops at the loading/unloading position under the control of the vehicle controller (step S76). Then, the second FOUP 3 on the second buffer B2 is moved onto the port P11 under the control of the stocker controller (step S77). Then, the second FOUP 3 on the port P11 is transferred to the second vehicle 10 under the control of the vehicle controller (step S78). After this, the second vehicle 10 travels toward the next conveyance destination (step S79). Then, the second arm 161 is moved to the second buffer B12 side (to return to the initial state) under the control of the stocker controller. This ends one cycle of the second continuous unloading processing.

As discussed above, with the second continuous loading processing of this embodiment, the first buffer B11 and the second buffer B12 are provided, which allow temporary placement of the FOUP 3 moved from the port P11 into the main body 120a of the stocker 120. The FOUP 3 is moved to the second buffer B12 whenever this FOUP 3 is placed on the first buffer B11. As a result, the first buffer B11 goes into an empty state right away. Consequently, continuous loading from the port P11 can be performed efficiently regardless of the operating state of the automatic conveyance apparatus 30.

### Features of Second Embodiment

Features of the second embodiment described above are as follows. The stocker 120 performs the loading of FOUPs 3 to and from the vehicles 10 that convey the FOUPs 3 and travel along the rail R1 provided to the ceiling. The stocker 120 comprises the main body 120a, the port P11, the automatic conveyance apparatus 30, the plurality of rack portions 21, the inter-port movement apparatus 150, and the inter-buffer movement apparatus 160, The main body 120a has a plurality of levels arranged in the vertical direction, and has at least one opening H1 provided corresponding to at least one of the plurality of levels. The port P11 is adjacent to the opening H1 on the outside of the main body 120a, and allows the FOUP 3 to be put in place. The automatic conveyance apparatus 30 is able to move the FOUP 3 in at least one horizontal direction and in the vertical direction within the main body 120a. The plurality of rack portions 21 are arranged in at least one horizontal direction at each of the plurality of levels within the main body 120a, and are configured to allow the placement of the FOUPs 3 moved by the automatic conveyance apparatus 30. The inter-port movement apparatus. 150 is able to move the FOUP 3 via the opening H1 between the port P11 and the first buffer B11 adjacent to the opening H1, among the plurality of rack portions. The inter-buffer movement apparatus 160 is able to move the FOUP 3 between the first buffer B11 and the second buffer B12 adjacent to the first buffer B11, among the plurality of rack portions.

With this stocker 120, the inter-buffer movement apparatus 160, such as a roller mechanism, a conveyor mechanism, or an arm mechanism, is provided in order to accommodate continuous loading. For example, after the inter-port movement apparatus 150 moves the first FOUP 3 from the port P11 to the first buffer B11, the inter-buffer movement apparatus 150 moves the first FOUP 3 placed on the first buffer B11 to the second buffer B12. After this, the automatic conveyance apparatus 30 moves the first FOUP 3 placed on the second buffer B12 to another rack portion, before or after the inter-port movement apparatus 150 moves the second FOUP 3 from the port P11 to the first buffer B11. Next, the inter-buffer movement apparatus 160 moves the second FOUP 3 placed on the first buffer B11 to the second buffer B12. Thus, the FOUP 3 is transferred to the second buffer B12 as soon as this FOUP 3 is placed onto the first buffer B11. This prepares for the loading of the next FOUP 3 from the port P11. Consequently, the FOUP 3 can be moved quickly from the port P11 to the second buffer B12 via the first buffer B11, so the FOUP 3 spends less time at the port P11. Or in other words, the vehicle 10 spends less time at the loading position.

The inter-buffer movement apparatus 160 is constructed separately from the automatic conveyance apparatus 30, but is not necessarily limited to this so long as the FOUP 3 can be moved between the first buffer B11 and the second buffer B12, and may have the same configuration as the automatic conveyance apparatus 30. Also, the inter-port movement apparatus 150 is not necessarily limited to the above described embodiment, so long as the FOUP 3 can be moved between the port P11 and the first buffer B11, and may have the same configuration as the automatic conveyance apparatus 30 and/or the inter-buffer movement apparatus 160.

Thus, at least two rack portions are provided to allow the temporary placement of a FOUP 3 that has been moved from the port P11 into the stocker 120, the FOUP 3 is retracted to the second buffer B12 whenever the FOUP 3 is placed on the first buffer B11, which allows the first buffer B11 to be emptied. Consequently, continuous loading from the port P11 can be carried out efficiently regardless of the operating state of the automatic conveyance apparatus 30.

The inter-port movement apparatus 150 may have the first arm 151 that can support the FOUP 3 from its bottom side, and a movement component that can move the first arm 151 between the first buffer B11 and the port P11. The inter-buffer movement apparatus 160 may have the second arm 161 having a second placement face that can support the FOUP 3 from its bottom side, and a movement component that can move the second arm 161 between the first buffer B11 and the second buffer B12. The port P11, the first buffer B11, and the second buffer B12 each have a support component (141, 123a, 123b) supporting a portion of the FOUP 3 different from the portion supported by the first arm 151 or the second arm 161.

With this mode, for example, the first arm 151 and the placement face 141 of the port P1 are configured so as to support different portions of the bottom face of the FOUP 3. Furthermore, the placement components 123a and 123b of the first buffer B11 and the first arm 151 are configured so as to support different portions of the bottom face of the FOUP 3. In addition, the placement components 123a and 123b of the second buffer B11 and the second arm 161 are configured so as to support different portions on the bottom face of the FOUP 3. In addition, the placement components 123a and 123b of the first buffer B11 and the second arm 161 are configured so as to support different portions on the bottom face of the FOUP 3. Therefore, the FOUP 3 supported by the support component of the port P11 is raised by the first arm 151 of the inter-port movement apparatus 150, moved above the placement components 123a and 123b of the first buffer B11, and then finally lowered and placed onto the placement components 123a and 123b of the first buffer B11. Furthermore, the FOUP 3 supported by the placement components 123a and 123b of the first buffer B11 is raised by the second arm 161 of the inter-buffer movement apparatus 160, moved above the placement components 123a and 123b of the second buffer B12, and then finally lowered and placed onto the placement components 123a and 123b of the second buffer B12.

As described above, the FOUPs 3 can be transferred between the first buffer B11 and the port P11 by the inter-port movement apparatus 150, and between the first buffer B11 and the second buffer B12 by the inter-buffer movement apparatus 160.

When a plurality of FOUPs 3 are to be loaded into the stocker 120, the stocker controller of the stocker 120 further controls the inter-port movement apparatus 150 so that a first FOUP 3 placed onto the loading port from a first vehicle 10 is moved from the port P11 to the first buffer B11, then controls the inter-buffer movement apparatus 160 so that the first FOUP 3 is moved to the second buffer B12, and then controls the inter-port movement apparatus 150 so that a second FOUP 3 placed onto the port P11 from a second vehicle 10 is moved from the port P11 to the first buffer B11.

With this mode, the inter-port movement apparatus 150 and the inter-buffer movement apparatus 160 are controlled in an orderly fashion, and a first FOUP 3 and a second FOUP 3 can be continuously and efficiently loaded.

### Other Embodiments

Embodiments of the present invention have been described above, but the present invention is not limited to or by the above embodiments, and various modifications are possible without departing from the gist of the invention. In particular, the embodiments and modification examples given in this specification can be combined as needed.

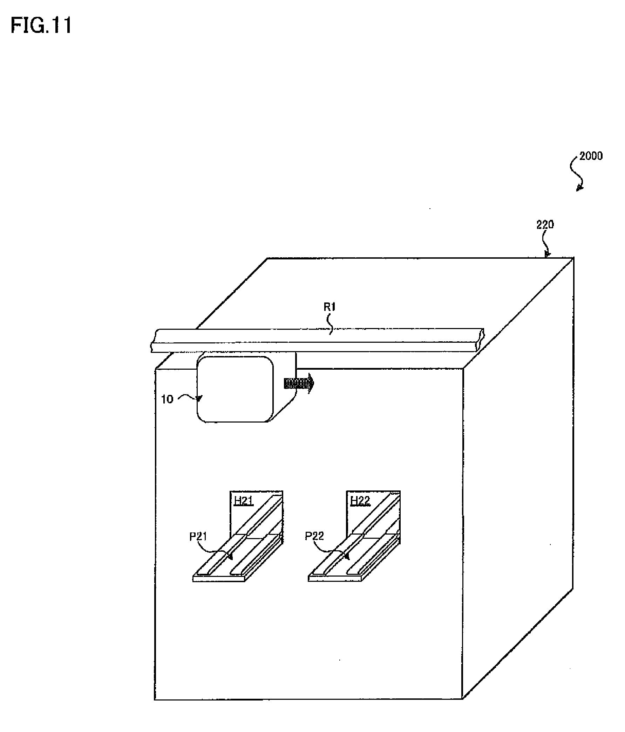

Next, an example of the storage container pertaining to the present invention will be described with reference to FIG. 11. FIG. 11 is an oblique view of a conveyance system comprising an example of the storage container pertaining to the present invention.

With the conveyance system 2000 in FIG. 11, a first opening H21 and a second opening H22 are provided to a stocker 220 main body. The stocker 220 comprises a first port P21 that is adjacent to the first opening H21, and a second port P22 that is adjacent to the second opening H22. The stocker controller that controls the various components of this stocker 220 sets the first port P21 as a port dedicated to loading, and the second port P22 as a port dedicated to unloading. In this case, the above-mentioned intra-storage container buffers serve to work for the first and second ports P21 and P22, which allows the number of FOUPₛ 3 that can be loaded and unloaded to and from the stocker 220 to be doubled. Also, two intra-storage container buffers serve to work for just the first port P21 dedicated to loading, which shortens the time it takes for loading, which is longer than the time for unloading, and allows continuous loading to be performed more efficiently.
In the above embodiments, the number of rack portions at the buffer near the entrance was two, but the present invention is not limited to this, and the number of rack portions at the buffer may be three or more.

### REFERENCE SIGNS LIST

- 3: FOUP (article)
- 4: flange
- 5: concave component
- 6: concave component
- 10: vehicle (transporting carriage)
- 10a: main body
- 11: hoist (elevator)
- 12: belt
- 13: gripper (holding apparatus)
- 20: stocker (storage container)
- 20a: main body (housing)
- 21: rack portion (fixed rack portion)
- 22: convex component
- 23: movable rack portion
- 23a: conveyor belt
- 23b: conveyor belt
- 30: automatic conveyance apparatus (internal movement apparatus)
- 31: placement component
- 32: convex component
- 33: roller
- 34: vertical guide
- 34a: mechanism
- 34b: rotary component
- 35: arm
- 39: shift mechanism (rack portion shift apparatus)
- 40: buffer apparatus
- 41: conveyor (in-out movement apparatus)
- 41a: conveyor portion
- 43: motor
- 44: drive roller
- 45: auxiliary roller
- 46: transmission shaft
- 47: linking component
- 48: shift guide
- 49: motor
- 50: ball screw
- 100: conveyance command component
- 101: vehicle controller
- 102: stocker controller (controller)
- 120: stocker
- 120a: main body
- 123: rack portion
- 123a: placement component (support component)
- 123b: placement component (support component)
- 124: convex component
- 141: placement face (support component)
- 142: convex component
- 150: inter-port movement apparatus (in-out movement apparatus)
- 151: first arm (first placement component)
- 152: convex component
- 153: lateral guide
- 154: lateral motor
- 155: main body
- 156: elevator
- 157: motor
- 160: inter-buffer movement apparatus (inter-rack portion movement apparatus)
- 161: second arm (second placement component)
- 163: lateral guide
- 164: lateral motor
- 165: main body
- 166: elevator guide
- 167: elevator motor
- 220: stocker
- B1: first buffer (first rack portion)
- B2: second buffer (second rack portion)
- B11: first buffer (first rack portion)
- B12: second buffer (second rack portion)
- H1: opening (entrance)
- H2: opening
- H11: opening (entrance)
- H12: opening
- H12: opening
- P1: port
- P2: port
- P11: port
- P21: port
- P22: sport
- 1000: conveyance system
- 2000: conveyance system

## Claims

1. A storage container with which an article is loaded from a transporting carriage that transports the article and travels along a track provided on a ceiling, said storage container comprising:
a housing that has a plurality of levels therein that are arranged in the vertical direction, and that has at least one entrance provided to correspond to at least one of the plurality of levels;
a loading port that is adjacent to the entrance on the outside of the housing and on which the article can be placed;
an internal movement apparatus configured to move the article in at least one horizontal direction within the housing and also in the vertical direction;
a plurality of fixed rack portions arranged in the at least one horizontal direction at each of the plurality of levels within the housing, and are configured such that the article moved by the internal movement apparatus can be placed onto the fixed rack portions;
a movable rack portion having a first rack portion and a second rack portion which are linked to each other;
a rack portion shift apparatus configured to shift the movable rack portion between a first position, where the first rack portion is adjacent to the entrance, and a second position, where the second rack portion is adjacent to the entrance; and
an in-out movement apparatus configured to move the article, via the entrance, between the loading port and the first rack portion or the second rack portion positioned adj acent to the entrance.

2. The storage container according to Claim 1,
wherein the first rack portion and the second rack portion are linked in a first direction parallel to the direction in which the track extends near the entrance, and
the rack portion shift apparatus is configured to shift the movable rack portion in the first direction.

3. The storage container according to Claim 1, further comprising a controller with which:
when a plurality of articles are to be loaded into the storage container,
the controller is configured to:
control the in-out movement apparatus so that a first article placed onto the loading port from a first transporting carriage is moved from the loading port onto the first rack portion,
then control the rack portion shift apparatus so that the movable rack portion is shifted from the first position to the second position, and
then control the in-out movement apparatus so that a second article placed onto the loading port from a second transporting carriage is moved from the loading port onto the second rack portion.

4. The storage container according to Claim 2, further comprising a controller with which:
when a plurality of articles are to be loaded into the storage container,
the controller is configured to:
control the in-out movement apparatus so that a first article placed on the loading port from a first transporting carriage is moved from the loading port onto the first rack portion,
then control the rack portion shift apparatus so that the movable rack portion is shifted from the first position to the second position, and
then control the in-out movement apparatus so that a second article placed on the loading port from a second transporting carriage is moved from the loading port onto the second rack portion.

5. The storage container according to Claim 1,
wherein the distance between a support component of the loading port and the lower face of the transporting carriage stopped at a loading position is less than the height of one article.

6. The storage container according to Claim 5,
wherein the loading port has a positioning structure for positioning the article placed on the loading port, and
the transporting carriage has:
a main body having an opening that opens to allow the passage of the article moved horizontally by the in-out movement apparatus when the transporting carriage is stopped at the loading position;
a holder configured to hold the article in the main body; and
an elevator configured to go up and down so as to shift the article held by the holder between a set position set by the positioning structure and a released position where the article is released from said set position.

7. A storage container with which an article is loaded from a transporting carriage that transports the article and travels along a track provided on a ceiling, said storage container comprising:
a housing that has a plurality of levels therein that are arranged in the vertical direction, and that has at least one entrance provided to correspond to at least one of the plurality of levels;
a loading port that is adjacent to the entrance on the outside of the housing and on which the article can be placed;
an internal movement apparatus that is configured to move the article in at least one horizontal direction within the housing and also in the vertical direction;
a plurality of rack portions that are arranged in at least the one horizontal direction at each of the plurality of levels within the housing, and are configured such that the article moved by the internal movement apparatus can be placed onto the rack portions;
an in-out movement apparatus with which the article can be moved, via the entrance, between the loading port and a first rack portion adjacent to the entrance, among the plurality of rack portions; and
an inter-rack portion movement apparatus configured to move the article between the first rack portion and a second rack portion that is adjacent to the first rack portion, among the plurality of rack portions.

8. The storage container according to Claim 7,
wherein the in-out movement apparatus has:
a first placement component having a first placement face arranged to support the article from the bottom side thereof; and
a first movement component that is configured to move the first placement component between the loading port and the first rack portion,
the inter-rack portion movement apparatus has:
a second placement component having a second placement face that is arranged to support the article from the bottom side thereof; and
a second movement component that is configured to move the second placement component between the first rack portion and the second rack portion, and
the loading port, the first rack portion, and the second rack portion each have a support component that is arranged to support a portion of the article different from the portion of the article supported by the first placement component or the second placement component.

9. The storage container according to Claim 7, further comprising a controller with which:
when a plurality of articles are to be loaded into the storage container,
the controller is configured to:
control the in-out movement apparatus so that a first article placed on the loading port from a first transporting carriage is moved from the loading port onto the first rack portion,
then control the inter-rack portion movement apparatus so that the first article is moved from the first rack portion onto the second rack portion, and
then control the in-out movement apparatus so that a second article placed on the loading port from a second transporting carriage is moved from the loading port onto the first rack portion.

10. The storage container according to Claim 8, further comprising a controller with which:
when a plurality of articles are to be loaded into the storage container,
the controller is configured to:
control the in-out movement apparatus so that a first article placed on the loading port from a first transporting carriage is moved from the loading port onto the first rack portion,
then control the inter-rack portion movement apparatus so that the first article is moved from the first rack portion onto the second rack portion, and
then control the in-out movement apparatus so that a second article placed on the loading port from a second transporting carriage is moved from the loading port onto the first rack portion.

11. The storage container according to Claim 7,
wherein the distance between a support component of the loading port and the lower face of the transporting carriage stopped at a predetermined loading position along the track is less than the height of one article.

12. The storage container according to Claim 11,
wherein the loading port has a positioning structure for positioning the article placed on the loading port, and
the transporting carriage has:
a main body having an opening that opens to allow the passage of the article moved horizontally by the in-out movement apparatus when the transporting carriage is stopped at the loading position;
a holder configured to hold the article in the main body; and
an elevator configured to go up and down so as to shift the article held by the holder between a set position set by the positioning structure and a released position where the article is released from said set position.
